# EUROPEAN PATENT APPLICATION

(11) **EP 0 662 718 A2**
(43) Date of publication of application: **12.07.1995**
(21) Application number: 94309075.3
(22) Date of filing: 06.12.1994
(51) Int. Cl.: H01L 29/737, H01L 21/265, H01L 21/331

(54) **A method of decreasing the bandgap of silicon for bipolar heterojunction transistors**

(30) Priority: 21.12.1993 US 171305
(71) Applicant: UNITED TECHNOLOGIES CORPORATION, Hartford, CT 06101 (US)
(72) Inventor: Jerome , Rick C., Monument, Colorado 80132 (US); Post, Ian R C, Colorado Springs, Colorado 80917 (US)
(74) Representative: Gilding, Martin John

(57) **Abstract**

The present invention teaches a method and structure of decreasing the silicon bandgap of the base of a bipolar junction transistor. The method comprises the step of providing a semiconductor substrate having a base region with a silicon bandgap. The substrate further includes performance characteristics such as a current gain, BV_{ceo} and BV_{cbo} breakdown voltages, and a maximum operable temperature. Subsequently, the base region is implanted with a dose of a dopant, preferably Ge. Once doped, an annealing step is performed such that the base's silicon bandgap is substantially reduced, thereby increasing the BJT's current gain, BV_{ceo} and BV_{cbo} breakdown voltages, as well as its maximum operable temperature, while decreasing the base resistance R_{b} and transit time.

## Description

### Technical Field

This invention relates to the field of semiconductor devices, and more particularly bipolar junction transistors.

### Background Art

In the semiconductor industry, bipolar junction transistors ("BJT") are known and used in either amplifying or switching devices. As an amplifying device, BJTs amplify small alternating current ("AC") signals according to its current gain characteristics.

BJTs essentially comprise three doped active regions - an emitter, a base and a collector region. These regions form a first diode between the base and emitter and a second diode between the base and collector. Each diode junction can be forward or reversed biased depending on the external voltage applied thereto. Thus, the BJT is termed "forward active" when the emitter base junction diode is forward biased, while the collector base junction diode is reversed biased.

The performance characteristics, such as current gain and maximum operable temperature, of each BJT are limited by several physical parameters. These parameters include the silicon bandgap and breakdown voltage of each diode junction - the C-B (BV_{cbo}), E-B (BV_{ebo}), and C-E (BV_{ceo}) junctions. These breakdown voltages are limited by the maximum reverse bias voltages employable, and directly correspond to the amount of dopant implanted within each region of the device.

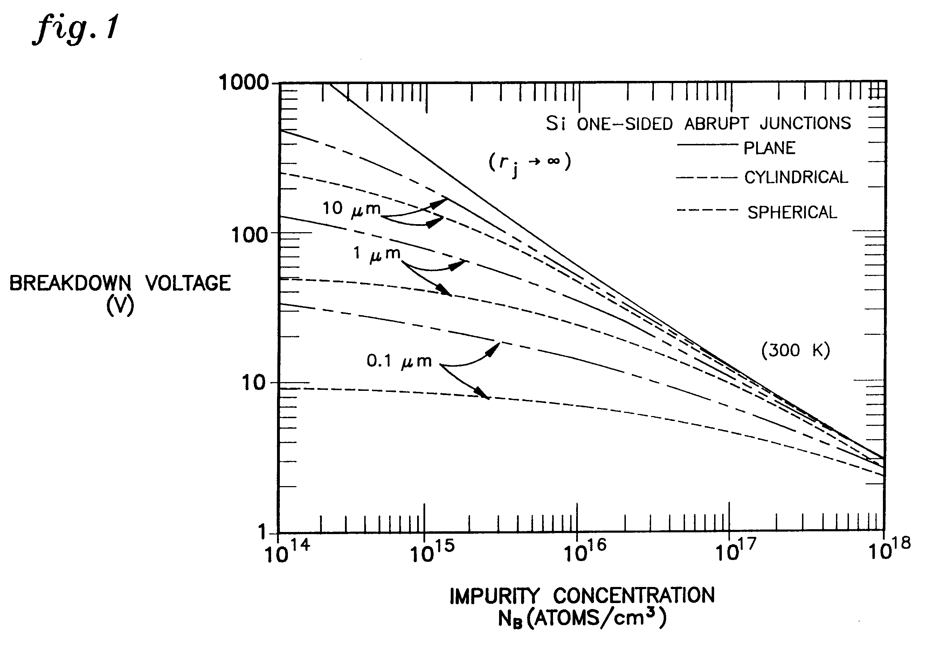

Further, the planar nature of BJTs also impact the breakdown voltages. This is in part related to the specific geometrics associated with implanted wells, as well as the natural propensity of implanted dopants to diffuse outward and sideways within a well region. As each junction comprises a planar area having substantially cylindrical edges, the breakdown voltage of each relevant junction is affected by the electric field characteristics in combination with its geometrics. Figure 1 illustrates this phenomena, by comparing the breakdown voltage-dopant impurity concentration curves for various radial junction depths (rⱼ) and geometric configurations. From this graph, a relationship can be deduced between the junction depth and the breakdown voltage. Thus, the shallower the junction depth, the lower the breakdown voltage.

The semiconductor industry has yet to formulate a method for reducing the silicon bandgap of the base without employing molecular beam epitaxy ("MBE") or chemical vapor deposition on a heterojunction bipolar transistor. As such, there is still a need for a technique which would increase the breakdown voltages of the BJT without affecting the junction depth. Further, there remains a demand for a method for increasing current gain characteristics, while decreasing temperature sensitivity.

### Disclosure of the Invention

The primary advantage of the present invention is to provide a method and structure for decreasing the silicon bandgap of the base of a BJT.

Another advantage of the present invention is to provide a method and structure for increasing the current gain of bipolar junction transistors.

A further advantage of the present invention is to provide a method and bipolar junction transistor structure for decreasing the base resistance, R_{b} due to enhanced mobility.

Still a further advantage of the present invention is to provide a method and bipolar junction transistor structure having faster a transit time due to enhanced mobility.

Yet, still another advantage of the present invention is to provide a method and structure for increasing the maximum operable temperature range of BJTs.

Yet another advantage of the present invention is to provide a method and structure for increasing the breakdown voltages, BV_{cbo} and BV_{ceo}, of bipolar junction transistors.

Yet another advantage of the present invention is to provide a method and structure for providing greater ion implant uniformity.

In order to achieve the advantages of the present invention, in one embodiment of the present invention, a method for decreasing the silicon bandgap of the base of bipolar junction transistors is disclosed. The method comprises the step of providing a semiconductor substrate having a base region with a silicon bandgap. The substrate further includes performance characteristics such as a current gain, BV_{ceo} and BV_{cbo} breakdown voltages, and a maximum operable temperature. Subsequently, the base region is implanted with a dose of a dopant, preferably Ge. Once doped, an annealing step is performed such that the base's silicon bandgap is substantially reduced, thereby increasing the BJT's current gain, BV_{ceo} and BV_{cbo} breakdown voltages, its maximum operable temperature, while decreasing the transit time and base resistance.

In a second embodiment, a bipolar junction transistor structure is provided. Here, a semiconductor substrate comprising a base having a silicon bandgap, an emitter formed within the base region, and a collector is disclosed. The substrate further comprises a base implanted with a base type dopant, an emitter implanted with a emitter type dopant and a collector implanted with a collector type dopant. Moreover, the substrate further comprises means for reducing said silicon bandgap to approximately 0.9 eV, thereby increasing the current gain, maximum operable temperature, and BV_{ceo} and BV_{cbo} breakdown voltages and decreasing the transit time and base resistance of the BJT.

Other aspects and advantages will become apparent to those skilled in the art from the following detailed description read in conjunction with the appended claims and the drawings attached hereto.

### Brief Description of the Drawings

The present invention will be better understood from reading the following description of non-limited embodiments, with reference to the attached drawings, wherein below:
Figure 1 illustrates the characteristics of breakdown voltage versus time for several different radii of curvatures;
Figure 2 illustrates a semiconductor structure formed according to a first step of a first embodiment of the present invention;
Figure 3 illustrates a semiconductor structure formed according to a second step of the first embodiment of the present invention;
Figure 4 illustrates a semiconductor structure formed according to a third step of the first embodiment of the present invention; and
Figure 5 illustrates a semiconductor structure formed according to a fourth step of the first embodiment of the present invention.

It should be emphasized that the drawings of the instant application are not to scale but are merely schematic representations and are not intended to portray the specific parameters or the structural details of the invention, which can be determined by one of skill in the art by examination of the information herein.

### Detailed Description of the Invention

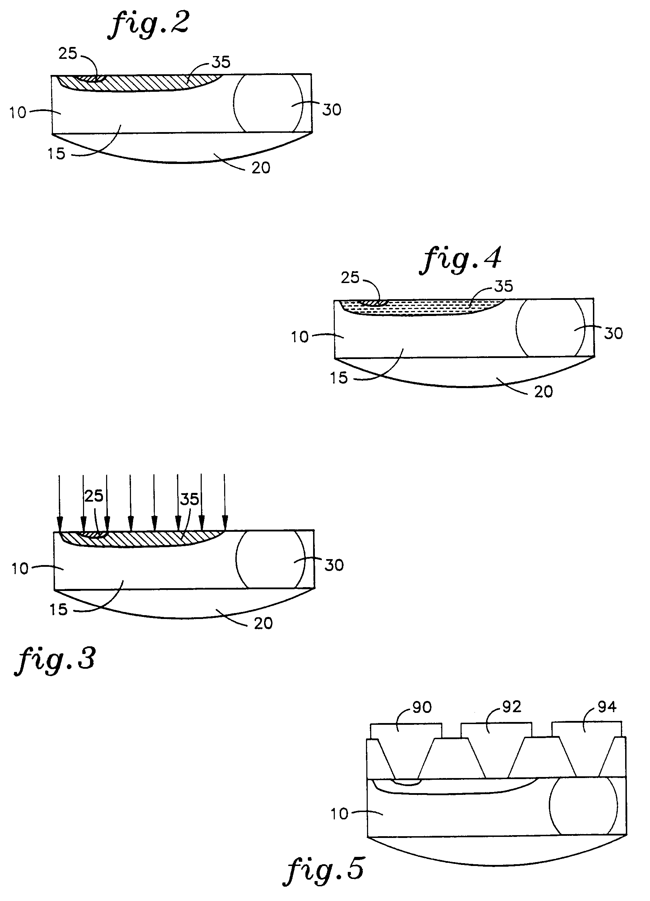

Referring to Figure 2, a semiconductor structure is depicted according to a first step of the first embodiment of the present invention. As shown, a semiconductor substrate 10 is provided comprising various dopant regions to support the proper operation of a bipolar junction transistor ("BJT"). The particular dopants employed for there regions are dependent on the conductivity type - PNP or NPN - of the intended BJT. For the purposes of illustration, the BJT described hereinbelow will have, though not be limited to, a PNP type conductivity configuration.

Being a PNP type transistor, substrate 10 comprises a P⁻ well 15 having a diffusion depth substantially in the range of 2.0 pm to 3.0 µm and a P⁺ buried layer 20. Substrate 10 further comprises a P⁺ sink deep diffusion region 30 having a diffusion depth of approximately 3 µm.

Formed within P⁻ well 15 is an N⁻ base 35. N⁻ base 35 has a junction depth of approximately 0.3 µm. Further, N⁻ base 35 comprises a silicon bandgap of approximately 1.1 eV. N⁻ base 35 comprises an intrinsic base region subjacent a P⁺ emitter region 25 and an extrinsic base region located between P⁺ emitter region 25 and N⁻ base 35. N⁻ base 35 is formed by implanting a base type dopant and performing an annealing step.

Additionally the P⁺ emitter region 25 is formed within N⁻ base well 35. In the preferred embodiment of the present invention, a polysilicon emitter is employed having a P⁺ emitter region 25 junction depth of approximately 0.1 µm. Alternatively, a non-polysilicon emitter can also are used. The junction depth of the N⁻ base well 35 of non-polysilicon emitter devices should be approximately 0.1 µm to 0.2 µm. Further, to prevent emitter spiking through junction, a barrier metal of 1000Å to 2000Å, such as TiW comprising 10% Ti and 90% W, is necessary between the non-polysilicon emitter and the substrate.

It should be noted that by this arrangement, a minority carrier current will conduct between from the base and the emitter through N⁻ base 35. Similarly, the majority carrier current is conducted from the emitter to the collector. The majority carrier current takes a path through P⁺ emitter region 25, N⁻ base 35, P⁻ base 15, P⁺ buried layer 20, and P⁺ sink deep diffusion region 30.

Given this configuration, it should apparent to one of ordinary skill in the art that substrate 10 comprises several characteristics inherent to BJTs. These characteristics comprises a current gain, a maximum operable temperature, and various breakdown voltages, including BV_{cbo} and BV_{ceo}. These characteristics all are dependent on the silicon bandgap of the N⁻ base 35, or the base region.

Referring to Figure 3, a semiconductor structure is depicted according to a second step of the first embodiment of the present invention. Here, the base, N⁻ base 35, is implanted with a dose of a dopant. In the preferred embodiment, both the extrinsic and intrinsic regions of N⁻ base 35 are implanted. In the alternative, the intrinsic region of N⁻ base 35 alone can be implanted. In this alternate embodiment, the benefits and advantages of the preferred embodiment present invention may not be realized in their entirety.

The dopant employed can be selected from group IV elements of the periodic table. However, germanium (Ge) is the preferred dopant. Thus, by implanting into the silicon a mole fraction of 5% to 10% Ge, a strain is placed on the silicon crystalline lattice structure, thereby altering its bandgap and creating a SiGe formation.

The concentration of the dose of the implant is of particular significance. In one embodiment of the present invention, P⁺ emitter region 25 is preferably formed within N⁻ base well 35. As such, the dose of the implanted dopant must be sufficiently low in concentration and substantially deep enough so as to prevent diffusion into the emitter. It has been observed that a dose concentration substantially in the range of 5 percent to 10 percent of the dopant within the base region is preferred. Thus, the projected range ("R_{P}") of the implant is substantially equivalent to the collector-base metallurgical junction, while deeper than the emitter-base metallurgical junction.

However, it should be noted that in an alternate embodiment, this implanting step is performed prior to the formation of the emitter region, P⁺ emitter region 25. Under these criterion, the dopant concentration is not of equal significance.

Referring to Figure 4, the result of a fourth step of the first embodiment of the present invention is depicted. Once N⁻ base 35 has been implanted with the dopant, an annealing step is performed. The step of annealing can be realized by several techniques known to one of ordinary skill in the art. One such approach employs a furnace in order to apply a temperature cycle of roughly 900°C for 10 minutes. This step requires applying a temperature substantially in the range of 800 to 900°C for a time substantially in the range of 5 minutes to 30 minutes. This step of annealing can be additionally realized by means of rapid thermal annealing ("RTA") wherein a temperature substantially in the range of 1000°C to 1150°C is obtained for a time substantially in the range of 10 second to 20 seconds.

As a result of the fourth step, the resultant BJT has improved performance characteristics. These include increased current gain, a higher maximum operable temperature, and greater BV_{ceo} and BV_{cbo} breakdown voltages. These enhancements are achieved by the reduction of silicon bandgap of the base region, N⁻ base 35, from approximately 1.1 eV to approximately 0.9 eV, particularly due to the SiGe formation.

Referring to Figure 5, a completed BJT transistor is illustrated. Here, polysilicon contacts, 90, 92 and 94 are formed for the emitter, base and collector of the BJT. These contacts can be fabricated through various techniques known in the art, which include the step of patterning and etching.

In accordance with the embodiments disclosed herein, a bipolar junction transistor can be fabricated having increased current gain, a higher maximum operable temperature, and greater BV_{ceo} and BV_{cbo} breakdown voltages. This BJT comprises a semiconductor substrate having a base having a base type dopant and an initial silicon bandgap of 1.1 eV. Further, the semiconductor substrate comprises an emitter, formed within the base, comprising an emitter type dopant. The substrate additionally comprises a collector having a collector type dopant.

The BJT further comprises means for reducing the initial silicon bandgap of the base from 1.1 eV to 0.9 eV. By this means, the resultant BJT comprises improved performance characteristics, which includes increased current gain, a higher maximum operable temperature, greater BV_{ceo} and BV_{cbo} breakdown voltages, a faster transit time and a reduced base resistance. These improvements are realized by an additional dopant implanted within the base of the BIT having a projected range substantially equivalent to the collector-base metallurgical junction. The additional is an element selected from group IV of the periodic table, and preferably Ge.

While the particular invention has been described with reference to illustrative embodiments, this description is not meant to be construed in a limiting sense. It is understood that although the present invention has been described in a preferred embodiment, various modifications of the illustrative embodiments, as well as additional embodiments of the invention, will be apparent to persons skilled in the art upon reference to this description without departing from the spirit of the invention, as recited in the claims appended hereto. It is therefore contemplated that the appended claims will cover any such modifications or embodiments as fall within the true scope of the invention.

Thus, for example, the present invention is the present invention is not limited to a particular BJT conductivity types, but rather both PNP and NPN bipolar junction transistors. Further, the present invention is applicable to integrated injection logic (I²L) devices, and both high and low voltage, as well as digital and linear BJTs.

In that same light, the present invention can be employed in and applied to lateral PNP (LPNP) and NPN (LNPN) technology. In lateral BJT devices, it should be apparent to one of ordinary skill that implant base width must not overlap into the P emitter region. However, such an overlap into the P collector region is actually preferred. Further, because of their lateral configuration, the breakdown voltages of LNPN and LPNP devices are not likely impacted by the present invention, though the current gain, temperature operability, transit time, and base resistance (R_{b}) are nonetheless enhanced.

## Claims

1. A method of fabricating a bipolar junction transistor ("BJT"), comprising the steps of:
providing a semiconductor substrate having a base region, said base region having a silicon bandgap, said substrate having a current gain, BV_{ceo} and BV_{cbo} breakdown voltages, maximum operable temperature, transit time and said base resistance;
implanting said base region with a dose of a dopant, said dopant comprising a group IV element; and
annealing said dopant such that said silicon bandgap is substantially reduced, thereby enhancing said current gain, said BV_{ceo} and BV_{cbo} breakdown voltages, said maximum operable temperature, said transit time and said base resistance.

2. The method of claim 1, wherein an emitter region is formed within said base region, and said dose of said dopant is sufficiently low in concentration and substantially deep enough so as to prevent diffusion into said emitter region.

3. The method of claim 2, wherein said dose concentration of said dopant is substantially in the range of 5 percent to 10 percent within said base region.

4. The method of any one of the preceding claims, wherein said providing a semiconductor substrate comprises the steps of:
implanting an emitter with an emitter type dopant;
implanting a collector with a collector type dopant; and
implanting said base with a base type dopant.

5. The method of any one of the preceding claims, wherein said dopant is Ge.

6. The method of any one of the preceding claims, wherein said annealing comprises the step of rapid thermal processing.

7. A method of fabricating a bipolar junction transistor ("BJT") having improved current gain, maximum operable temperature, and BV_{ceo} and BV_{cbo} breakdown voltages, transit time and base resistance characteristics, comprising the steps of:
providing a semiconductor substrate having a base, emitter and collector region, said base implanted with a base type dopant, said emitter implanted with an emitter type dopant, said collector implanted with a collector type dopant, said base region having a silicon bandgap, said substrate having a current gain, maximum operable temperature, BV_{ceo} and BV_{cbo} breakdown voltages, transit time and a base resistance;
implanting said base region with a dose of a first dopant, said first dopant comprising a group IV element; and
annealing said dopant such that said silicon bandgap is substantially reduced, thereby increasing said current gain, said BV_{ceo} and BV_{cbo} breakdown voltages, and said maximum operable temperature, while decreasing said transit time and said base resistance.

8. The method of claim 7, wherein said emitter region is formed within said base region, and said dose of said dopant is sufficiently low in concentration and substantially deep enough so as to prevent diffusion into said emitter region.

9. The method of any one of the preceding claims, wherein said implanting comprises a projected range ("R_{P}"), said R_{P} being substantially equivalent to a collector-base metallurgical junction and substantially deeper than an emitter-base metallurgical junction.

10. The method of claims 7 to 9, wherein said first dopant comprises Ge.

11. The method of any one of the preceding claims, wherein said reduced silicon bandgap is approximately 0.9 eV.

12. The method of any one of the preceding claims, wherein said step of annealing comprises applying a temperature substantially in the range of 800°C to 900°C for a time substantially in the range of 5 minutes to 30 minutes.

13. The method of any one of claims 7 to 12 wherein said step of annealing comprises the step of rapid thermal annealing ("RTA"), said RTA applying a temperature substantially in the range of 1000°C to 1150°C for a time substantially in the range of 10 second to 20 seconds.

14. A bipolar junction transistor ("BJT") comprising:
a semiconductor substrate comprising a base, an emitter, and a collector, said substrate having a base implanted with a base type dopant, an emitter implanted with a emitter type dopant and a collector implanted with a collector type dopant, said base having a silicon bandgap, said emitter being formed within said base region; and
means for reducing said silicon bandgap to approximately 0.9 eV, thereby increasing a current gain, a maximum operable temperature, and a BV_{ceo} and a BV_{cbo} breakdown voltages, and decreasing a transit time and base resistance of said BJT.

15. The bipolar junction transistor of claim 14 wherein said means for reducing said silicon bandgap comprises a dopant implanted and annealed within said base, said implanted and annealed dopant comprising a group IV element.

16. The bipolar junction transistor of either one of claims 14 and 15 wherein said dopant comprises a dose concentration substantially in the range of 5 percent to 10 percent within said base region.

17. The bipolar junction transistor of claim 15 wherein said implanted dopant comprises a range ("R_{P}") substantially equivalent to a collector-base metallurgical junction and substantially deeper than an emitter-base metallurgical junction.
